# EUROPÄISCHE PATENTSCHRIFT

(11) **EP 1 985 912 B1**
(45) Veröffentlichungstag und Bekanntmachung des Hinweises auf die Patenterteilung: **07.06.2017**
(21) Anmeldenummer: 07008579.0
(22) Anmeldetag: 26.04.2007
(51) Int. Cl.: F21K 99/00

(54) **Operationsleuchte**
Operating light
Lampe chirurgicale

(43) Veröffentlichungstag der Anmeldung: 29.10.2008
(73) Patentinhaber: Frowein EZH GmbH, 42117 Wuppertal (DE)
(72) Erfinder: Diez, Ingolf, 78532 Tuttlingen (DE)
(74) Vertreter: Feder Walter Ebert

(56) Entgegenhaltungen:
- EP-A- 1 462 711
- EP-A1- 0 568 935
- EP-A1- 1 433 998
- EP-A1- 1 693 615
- EP-A2- 1 628 070
- WO-A-00/58664
- WO-A-2006/062047
- DE-A1- 10 009 783
- DE-A1- 10 164 033
- DE-U1- 20 002 043
- DE-U1- 20 002 565

## Beschreibung

Die Erfindung betrifft eine Operationsleuchte. Insbesondere betrifft die Erfindung eine Operationsleuchte mit wenigstens einem Leuchtelement und wenigstens einem optischen Abbildungssystem, wobei jedes Leuchtelement mehrere Lichtquellen mit Emissionen unterschiedlicher Spektren hat.

Der Begriff "Operationsleuchte" steht hier für eine Leuchte, die für medizinische Anwendungen geeignet ist. Die erfindungsgemäße Operationsleuchte soll also insbesondere geeignet sein zu Beleuchtung eines Operationsfeldes und zum Beispiel auch zur Beleuchtung eines Mundinnenraumes (Dentalleuchte). Solche Operationsleuchten dienen auch zu Diagnosezwecken und zu Behandlungen im Bereich der Veterinärmedizin.

Der Stand der Technik kennt Operationsleuchten mit optischen Abbildungssystemen. Beispielsweise zeigt die EP 1 741 975 A2 eine Operationsleuchte, bei der eine Anordnung von Reflektoren ein optisches Abbildungssystem bildet.

Ebenfalls bekannt sind Operationsleuchten, die Lichtquellen unterschiedlicher Emissionsspektren verwenden. Beispielsweise zeigt die EP 1 568 936 A1 eine Operationsleuchte, bei der jedes Leuchtelement über drei Lichtquellen unterschiedlicher Emissionsspektren verfügt, wobei die Emissionen der Lichtquellen im Leuchtfeld (dem Operationsfeld) überlagert werden. Bei manchen derartigen Aufbauten ist das Spektrum der Strahlung im Leuchtfeld nicht an allen Stellen gleich. Je nach Ausrichtung und Abstrahlcharakteristik der verschiedenen Lichtquellen können sich Bereiche im Leuchtfeld ergeben, an denen die Strahlung ein anderes Spektrum aufweisen als an anderen Stellen. Dies führt dazu, dass die Farbwahrnehmung des Operateurs nicht im gesamten Operationsfeld konstant ist.

Darüber hinaus bewirken Gegenstände, die in den Strahlengang zwischen den Lichtquellen und dem Operationsfeld eingebracht werden, beispielsweise eine Hand oder ein chirurgisches Instrument, dass sich im Leuchtfeld Schatten abzeichnen, die verschiedenfarbige, irritierende Schattenränder haben. Derartige Schattenränder wirken sich negativ auf die Wahrnehmung und Konzentrationsfähigkeit eines Operateurs aus und sind daher zu vermeiden.

Operationsleuchten, bei denen die Emissionen von Lichtquellen verschiedener Spektren im Leuchtfeld überlagert (gemischt) werden, erreichen häufig auch nicht das angestrebte überlagerte Emissionsspektrum. Es wird ein überlagertes Spektrum angestrebt, welches einer bestimmten Farbtemperatur im sichtbaren Bereich entspricht. Eine Farbtemperatur ist ein bestimmtes Emissionsspektrum, welches physikalisch wohldefiniert ist. Der Grad, in dem ein Emissionsspektrum in dem vom Menschen sichtbaren Bereich das Spektrum einer vorgegebenen Farbtemperatur erreicht, wird mit einem Farbwiedergabeindex angegeben. Ein Farbwiedergabeindex von 100 bezeichnet die vollständige Entsprechung des überlagerten Spektrums mit der vorgegebenen Farbtemperatur im vom Menschen sichtbaren Bereich. Bei sinkenden Farbwiedergabeindizes werden die Farben der beleuchteten Gegenstände von einem menschlichen Beobachter als mehr und mehr unnatürlich empfunden. Ein Farbwiedergabeindex von 85 sollte bei Operationsleuchten nicht unterschritten werden.

Die EP 1 433 998 A1 offenbart eine Operationsleuchte. Ein Lichtmodul weist eine Mehrzahl Leuchtdioden auf. Eine Leuchtquelle umfasst eine Matrix von Leuchtelementen. Die Lichtmodule sind derart angeordnet, dass sich die auszuleuchtenden Bereiche zweier benachbarter Module teilweise überlappen, um eine Überlappungszone zu bilden. Zwei benachbarte beleuchtete Bereiche 30 überlappen sich über die Hälfte ihrer Fläche, so dass jeder Ort in dem ausgeleuchteten Feld Licht von zwei Lichtmodulen erhält. Der ausgeleuchtete Bereich ist der Patient. Mittels der Überlappungszonen wird der aufgrund eines Hindernisses erzeugte Schatten kompensiert. Zum Detektieren eines Schattenbereichs wird eine CCD-Kamera verwendet.

Die WO 2006/062047 A1 offenbart eine Beleuchtungsquelle, die in der Lage ist, Licht unter unterschiedlichen Farbtemperaturen abzugeben, indem die Intensitätsverhältnisse der lichtemittierenden Einrichtungen geändert wird, wobei jede der lichtemittierenden Einrichtungen Licht mit einer von zumindest vier Farben abgibt.

Der Erfindung liegt die Aufgabe zugrunde, eine Operationsleuchte zu schaffen, die für einen Betrachter den Eindruck einer einfarbigen Lichtquelle einer vorgegebenen Farbtemperatur hervorruft, ohne die oben angegebenen Nachteile aufzuweisen.

### KURZER ABRISS DER ERFINDUNG

Hierzu stellt die Erfindung bereit eine Operationsleuchte mit wenigstens einem Leuchtelement und wenigstens einem optischen Abbildungssystem, wobei das Leuchtelement wenigstens zwei Lichtquellen hat und jede Lichtquelle Emissionen eines Spektrums aussendet, wenigstens zwei Lichtquellen jedes Leuchtelements Emissionen zueinander verschiedener Spektren aussendet, und wobei die Lichtquellen des Leuchtelements derart in einem Abstand von einer optischen Achse des Leuchtelements angeordnet sind, dass die Emissionen der Lichtquellen ortsgleich überlagert werden, bevor sie auf das optische Abbildungssystem treffen.

Dabei soll der Abstand eines Zentrums jeder Lichtquelle eines Leuchtelements zur optischen Achse des Leuchtelements weniger als ca. 4-5 mm betragen. In einer weiteren Ausführungsform soll dieser Abstand 3 mm betragen. Vorzugsweise ist der genannte Abstand für jede Lichtquelle eines Leuchtelements gleich.

Das optische Abbildungssystem kann wenigstens einen Reflektor aufweisen. Beispielsweise kann jedem Leuchtelement ein Reflektor zugeordnet sein. Alternativ kann auch eine Anzahl Leuchtelemente einem gemeinsamen Reflektor zugeordnet sein. Insbesondere kann auch ein einziger oder mehrere Reflektoren allen Leuchtelementen zugeordnet sein. Das optische Abbildungssystem ist nicht auf Reflektoren beschränkt und kann auch weitere bzw. alternative optische Elemente aufweisen, wie beispielsweise Linsen, Filter, Beschichtungen, Blenden und ähnliche.

Die Spektren der Emissionen jeder Lichtquelle können einer der Farben weiß, warmweiß, rot, grün oder amber entsprechen. Es sind auch andere Kombinationen von Spektren möglich. Es ist ebenfalls möglich, eine oder mehrere Lichtquellen eines Leuchtelements in der gleichen Farbe oder Gruppen von gleichfarbigen Lichtquellen in einem Leuchtelement vorzusehen. Beispielsweise kann ein Leuchtelement zwei Lichtquellen der Farbe warmweiß, eine Lichtquelle der Farbe grün und eine Lichtquelle der Farbe amber umfassen. Alternativ kann z. B. ein Leuchtelement eine Lichtquelle der Farbe blau, zwei Lichtquellen der Farbe grün und zwei Lichtquellen der Farbe rot umfassen. Die Anzahl der Lichtquellen pro Farbe kann so gewählt werden, dass die maximale Intensität der Emissionen der Lichtquellen jeder Farbe, bezogen auf die menschliche Wahrnehmung, im Wesentlichen gleich ist.

Die Lichtquellen können Halbleiterkristalle sein. Dies schließt den Fall mit ein, in dem ein Halbleiterkristall mit einer Lumineszenzschicht versehen ist, welche die vom Halbleiterkristall ausgehenden Emissionen eines bestimmten Spektrums in Emissionen eines anderen Spektrums umwandelt. Eine derartige Vorgehensweise ist insbesondere für die Erzeugung der Farbtöne weiß und warmweiß aus einem blauen Emissionsspektrum im Stand der Technik bekannt.

Die Lichtquellen können Leuchtdioden (LED) sein. In diesem Fall kann sich jeweils ein Halbleiterkristall mit einem Trägersubstrat und Elektroden in einem Gehäuse befinden und separat handhabbar sein. Es sind auch Aufbauten mit mehreren Halbleiterkristallen in einem Gehäuse möglich. Es können auch mehrere Halbleiterkristalle unterschiedlicher Emissionsspektren in einem LED-Gehäuse verwendet werden.

Die Lichtquellen eines Leuchtelements können in einem gemeinsamen Gehäuse untergebracht sein. Sind die Lichtquellen Halbleiterkristalle, können beispielsweise mehrere Halbleiterkristalle mit ihren Elektroden auf einem gemeinsamen Träger in einem gemeinsamen Gehäuse angeordnet sein.

Die Emissionen jeder Lichtquelle können eine einstellbare Intensität haben und die Intensität der Emissionen jeder Lichtquelle kann mittels einer Stellgröße variabel sein. Diese Stellgröße kann beispielsweise ein elektrischer Strom oder/und eine elektrische Spannung einer Lichtquelle sein. In einer weiteren Ausführungsform kann beispielsweise auch eine elektrische Spannung oder ein elektrischer Strom in ihrem Verlauf über der Zeit veränderlich sein. Beispielsweise kann eine Änderung der Intensität der Emissionen einer Lichtquelle durch Änderung eines Tastverhältnisses einer Ansteuerung einer Lichtquelle mittels Pulsweitenmodulation (PWM) erfolgen. Die einer Lichtquelle zugeordnete Stellgröße kann nur diese oder mehrere Lichtquellen betreffen. Insbesondere ist es möglich, die Intensität von Gruppen von Lichtquellen mittels einer gemeinsamen Stellgröße zu beeinflussen. Beispielsweise können mehrere Lichtquellen der gleichen Farbe mittels einer gemeinsamen Stellgröße beeinflussbar sein.

Die Intensität der Emissionen jeder Lichtquelle eines Leuchtelements kann derart verändert werden, dass die auf das optische Abbildungssystem treffenden, im gleichen Ort vor dem ersten Abbildungselement überlagerten Emissionen der Lichtquellen eines Leuchtelements ein vorgegebenes Spektrum aufweisen. Das vorgegebene überlagerte Spektrum entsteht noch vor dem Auftreffen der Emissionen der Lichtquellen auf das optische Abbildungssystem durch eine Überlagerung der Emissionen unterschiedlicher Spektren und möglicherweise auch unterschiedlicher Intensitäten.

Das Spektrum der auf das optische Abbildungssystem treffenden überlagerten Emissionen der Lichtquellen eines Leuchtelements soll bevorzugt mit einem Farbwiedergabeindex von wenigstens 90 einer vorgegebenen Farbtemperatur entsprechen. In einer weiteren Ausführungsform kann das Spektrum der überlagerten Emissionen der Lichtquellen einer vorgegebenen Farbtemperatur mit einem Farbwiedergabeindex von wenigstens 88 entsprechen.

Die vorgegebene Farbtemperatur kann im Bereich zwischen 3300 und 5500 K liegen. In einer weiteren Ausführungsform liegt die obere Grenze der Farbtemperatur bei etwa 5777 K. Diese Farbtemperatur entspricht in guter Näherung dem Emissionsspektrum der Sonne.

Insbesondere umfasst die Erfindung, Lichtquellen zu verwenden, deren im obigen Sinn überlagerte Emissionen bei geeigneter Einstellung der Emissions-Intensitäten der Lichtquellen mehreren unterschiedlichen Spektren vorgegebener Farbtemperaturen entsprechen können. Alternativ kann eine beliebige in einem vorgegebenen Bereich von Farbtemperaturen liegende Farbtemperatur eingestellt werden. In beiden Fällen kann die Einstellung so durchgeführt werden, dass der Farbwiedergabeindex der Farbtemperatur des Spektrums der überlagerten Emissionen einen vorbestimmten Wert nicht unterschreitet.

Ein Spektrum von Emissionen und insbesondere ihre Farbtemperatur ist bei LEDs allgemein unabhängig von ihrer absoluten Intensität. Bei Überlagerung von Emissionen unterschiedlicher Spektren ergibt sich die Farbtemperatur der überlagerten Emissionen aus den relativen Intensitäten der unterschiedlichen Spektren, also ihrem Intensitätsverhältnis. Die Intensität der überlagerten Emissionen bestimmt sich aus den absoluten Intensitäten der einzelnen Emissionen, also aus ihrer Summe.

Zur Veranschaulichung dieses Sachverhalts wird beispielhaft von einer Operationsleuchte ausgegangen, die über ein Leuchtelement mit drei Lichtquellen unterschiedlicher Spektren verfügt, wobei die Emissionsintensität jeder Lichtquelle individuell in einem Bereich von 0% bis 100% eingestellt werden kann. Die maximalen Intensitäten der drei Lichtquellen seien in dieser Betrachtung gleich groß. In einem ersten Beispiel werden die Emissionen der Lichtquellen mit Intensitäten von 20%, 20% und 30% zu einem bestimmten vorgegebenen Spektrum überlagert. Das gleiche überlagerte Spektrum könnte in einem zweiten Beispiel auch mit den pro Lichtquelle verdoppelten Emissionsintensitäten von 40%, 40% und 60% erzielt werden. Die Farbtemperatur der überlagerten Emissionen in diesem Beispiel entspricht der im ersten Beispiel, jedoch ist die Intensität der überlagerten Emissionen höher. In einem dritten Beispiel könnten Emissionen der Intensitäten 40%, 10% und 20% zu einem Spektrum überlagert werden, welches dem des ersten Beispiels nicht mehr entspricht, wobei jedoch die Intensität der überlagerten Emissionen der des ersten Beispiels entspricht. Die rührt daher, dass die Summe der einzelnen Intensitäten im ersten und dritten Beispiel gleich sind: 20% + 20% + 30% = 40% + 10% + 20%. Farbtemperatur und Intensität der überlagerten Emissionen lassen sich also getrennt voneinander durch die Beeinflussung der einzelnen Emissionsintensitäten der drei Lichtquellen einstellen.

Die Operationsleuchte kann eine Steuerung aufweisen, welche ausgebildet ist, den Zusammenhang zwischen der der Intensität der Emissionen einer Lichtquelle zugeordneten Stellgröße und einer tatsächlich erzielten Intensität der Emissionen dieser Lichtquelle zu bestimmen und aufgrund dieser Bestimmung die Intensität der Emissionen der Lichtquellen derart einzustellen, dass das Spektrum der überlagerten Emissionen der Lichtquellen einer vorgegebenen Farbtemperatur entspricht. Beispielsweise kann mittels der Steuerung eine Kalibrierung durchgeführt werden, die etwa Alterungseffekte oder Serienstreuungen der Intensitäten der Emissionen jeder einzelnen Lichtquelle oder von Gruppen von Lichtquellen berücksichtigt. Anschließend kann die Operationsleuchte so gesteuert werden, dass die genannten Abweichungen kompensiert und Intensitätsschwankungen der Emissionen im Bereich des Leuchtfeldes ausgeglichen werden.

Ein Verfahren zum Steuern einer Farbtemperatur einer Operationsleuchte mit wenigstens einem Leuchtelement, wobei das Leuchtelement wenigstens zwei Lichtquellen aufweist, welche Spektren aufweisende Emissionen aussenden, wobei wenigstens zwei Lichtquellen jedes Leuchtelements Emissionen zueinander verschiedener Spektren aussenden, kann die Schritte des Bestimmens des Zusammenhangs zwischen der der Intensität der Emissionen jeder Lichtquelle zugeordneten Stellgröße und der erzielten Intensität der Emissionen jeder Lichtquelle und des Steuerns der Intensitäten der Emissionen der Lichtquellen derart, dass das Spektrum der überlagerten Emissionen der Lichtquellen einer vorgegebenen Farbtemperatur mit einem Farbwiedergabeindex entspricht, der größer oder gleich einem vorgegebenen Farbwiedergabeindex ist, umfassen. Dieser Farbwiedergabeindex kann 90 sein. In einer weiteren Ausführungsform kann dieser Farbwiedergabeindex 88 sein.

Insbesondere kann das Verfahren eine Kalibrierungsphase und eine Betriebsphase aufweisen. In der Kalibrierungsphase kann beispielsweise mittels eines oder mehreren Sensoren im Strahlengang der Lichtquellen der Zusammenhang zwischen den Steuergrößen, die den Intensitäten der Emissionen der Lichtquellen zugeordnet sind und den Intensitäten der Emissionen der Lichtquellen bestimmt werden. Alternativ können auch einer oder mehrere Sensoren zusammen mit einem optischen Abbildungssystem verwendet werden. Die Ergebnisse dieser Bestimmung können in einer späteren Betriebsphase dazu genutzt werden, eine gewünschte Intensität der Emissionen einer oder mehrerer Lichtquellen im Leuchtfeld einzustellen, ohne einen Sensor einsetzen zu müssen.

Die Kalibrierungsphase kann beispielsweise in regelmäßigen Abständen wiederholt werden, um Alterungseffekten der Lichtquellen Rechnung zu tragen. In einer alternativen Ausführungsform können einer oder mehrere Sensoren derart angeordnet sein, dass eine Kalibrierung während des normalen Betriebs stattfinden kann. In noch einer weiteren Ausführungsform kann die Kalibrierung benutzergesteuert oder im Dialog mit einem einen Sensor führenden Benutzer durchgeführt werden.

### KURZE BESCHREIBUNG DER ZEICHNUNGEN

Nachfolgend werden Ausführungsbeispiele der Erfindung anhand der Zeichnungen näher erläutert. Es zeigen:
- Figur 1: eine schematische Darstellung einer Operationsleuchte;
- Figur 2: eine Darstellung einer Anordnung von drei Lichtquellen bezüglich einer optischen Achse eines Leuchtelements;
- Figur 3: eine schematische Darstellung einer Draufsicht auf ein Gehäuse mit drei Lichtquellen und
- Figur 4: eine schematische Darstellung einer Schnittansicht durch das Gehäuse aus Figur 3.

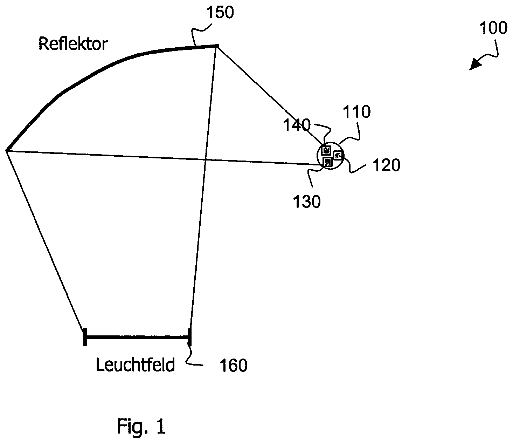

Figur 1 zeigt eine schematische Darstellung einer Operationsleuchte 100. Ein Leuchtelement 110 trägt drei Lichtquellen 120, 130 und 140. Nicht in dieser Darstellung erkennbar ist, dass die drei Lichtquellen 120-140 Emissionen unterschiedlicher Spektren abgeben. Das Spektrum der Lichtquelle 120 kann beispielsweise der Farbe warmweiß entsprechen, während die Emissionen der Lichtquelle 130 einer grünen Farbe und die Emissionen der Lichtquelle 140 der Farbe Amber entsprechen. Die Emissionen der Lichtquellen 120 bis 140 fallen auf den Reflektor 150, der die einfallenden Emissionen auf das Leuchtfeld 160 umlenkt.

Bei dieser Anordnung erfolgt eine homogene Überlagerung der unterschiedlichen Spektren der Emissionen der Lichtquellen 120 bis 140 in einem einzigen Raumwinkel bereits bevor die Emissionen auf dem Reflektor 150 auftreffen. Die überlagerten Emissionen im Strahlengang zwischen dem Reflektor 150 und dem Leuchtfeld 160 weisen also eine bestimmte Farbtemperatur mit einem bestimmten Farbwiedergabeindex auf. Ein in den Bereich zwischen dem Reflektor 150 und dem Leuchtfeld 160 eingebrachter nicht transparenter Körper, beispielsweise eine Hand oder ein chirurgisches Instrument, wirft also einen Schatten auf das Leuchtfeld 160, der keine Farbsäume hat. Aus der Perspektive des Leuchtfeldes 160 stellt sich das Leuchtelement 110 als punktförmige Lichtquelle des überlagerten Emissionsspektrums dar.

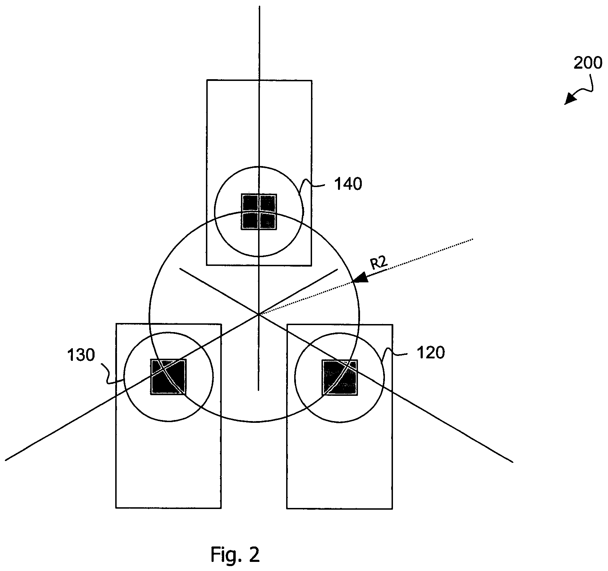

Figur 2 zeigt eine Darstellung einer exemplarischen Anordnung der drei Lichtquellen 120 bis 140. Jede der Lichtquellen 120 bis 140 ist eine Leuchtdiode (LED). Die Kreise stellen dabei die Gehäuse der Leuchtdioden dar, und das in der Mitte jedes Kreises angeordnete Quadrat repräsentiert den Halbleiterkristall. Details innerhalb der LEDs wie ein Trägersubstrat, Elektroden oder Bonddrähte sind nicht dargestellt. Jede der runden Leuchtdioden 120 bis 140 ist auf einem eigenen rechteckigen Träger angebracht.

Der Mittelpunkt des großen Kreises in der Mitte von Figur 2 bezeichnet die optische Achse des Leuchtelementes, dem die Lichtquellen 120 bis 140 zugeordnet sind. Diese Achse weist auf den Betrachter zu. Der Kreis mit dem Radius R2 um die optische Achse schneidet die Mittelpunkte jeder der Lichtquellen 120 bis 140. Der Abstand des Mittelpunktes jeder Lichtquelle 120 bis 140 von der optischen Achse ist also R2.

Damit das Leuchtelement, dem die Lichtquellen 120 bis 140 zugeordnet sind, als möglichst punktförmige Lichtquelle wirkt, ist der Abstand R2 nach Möglichkeit zu minimieren. Gute Ergebnisse wurden mit einem Abstand R2 von 4 bis 5 mm erzielt. Eine weitere Verbesserung konnte mit einem Abstand von etwa 3 mm erreicht werden. Bevorzugterweise ist der Abstand jedes Mittelpunktes jeder der Lichtquellen 120 bis 140 von der optischen Achse des Leuchtelements gleich.

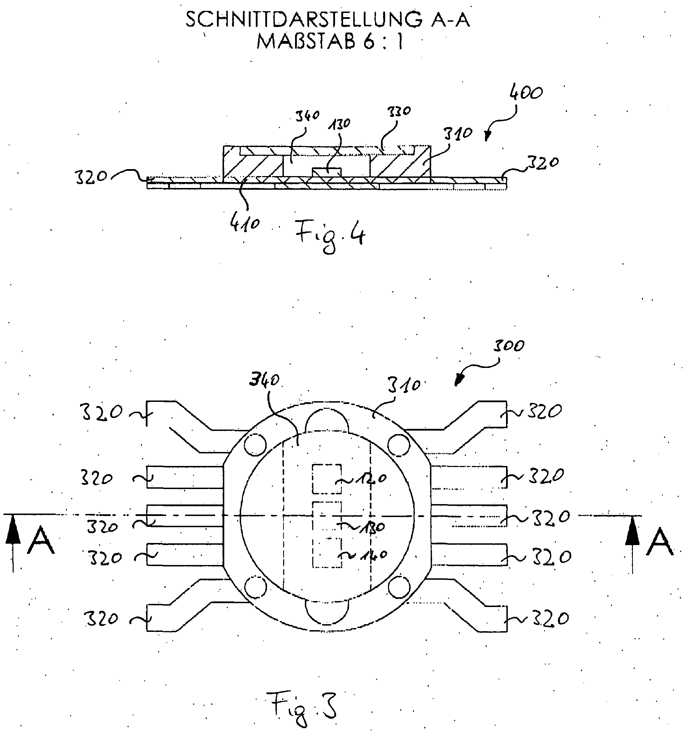

Figur 3 zeigt eine Darstellung einer Draufsicht auf ein Leuchtelement 300. Ein Gehäuse 310 trägt zehn Anschlüsse 320. Während einige der Anschlüsse 320 den in dem Gehäuse angeordneten Lichtquellen 120 bis 140 zugeordnet sind, dienen andere der Anschlüsse 320 Befestigungs- oder Wärmeableitungszwecken. Im dargestellten Ausführungsbeispiel sind die vier an den Ecken angebrachten, gekröpften Anschlüsse 320 zur Befestigung des Gehäuses 310 vorgesehen und besitzen keine elektrische Verbindung zu einer der Lichtquellen 120 bis 140. Die sechs gerade ausgeführten Anschlüsse 320 zu beiden Seiten des Gehäuses 310 dienen hingegen der Kontaktierung der Lichtquellen 120 bis 140. Das im wesentliche runde Gehäuse 310 weist eine konzentrische Öffnung mit einer transparenten Abdeckung 330 auf. Die Abdeckung 330 ist aus einem transparenten, farblosen Material wie beispielsweise Quarzglas gefertigt. Die Abdeckung 330 erlaubt es den Emissionen der Lichtquellen 120 bis 140, ungehindert zu passieren, und schützt die Lichtquellen 120 bis 140 vor Umwelteinflüssen wie beispielsweise eindringenden Gegenständen. Auch ist die Abdeckung 330 geeignet, eine Schutzatmosphäre im Innenraum des Gehäuses 310 aufrecht zu erhalten. Hierzu kann das Gehäuse 310 mit einem farblosen inerten Gas, beispielsweise einem Edelgas gefüllt sein. Auf diese Weise kann eine Lebensdauer verkürzende Oxidation der Lichtquellen 120 bis 140 vermieden werden.

Das Gehäuse 310 weist eine längliche Vertiefung 340 auf, in der die Lichtquellen 120 bis 140 angebracht sind. Jede der Lichtquellen 120 bis 140 verfügt über zwei Elektroden (nicht dargestellt), von denen jeweils eine mit einem Anschluss 320 verbunden ist. Im dargestellten Ausführungsbeispiel verfügt jede Elektrode jeder Lichtquelle 120-140 über zwei zugeordnete Anschlüsse 320. Wird eine größere Anzahl von Lichtquellen 120 bis 140 im Gehäuse 310 angeordnet, so kann es sinnvoll sein, einige der Elektroden mehrerer der Lichtquellen 120 bis 140 innerhalb des Gehäuses miteinander zu verbinden und mit nur einem der Anschlüsse 320 nach außen zu führen. Sind die Lichtquellen 120 bis 140 Halbleiterkristalle, so bietet es sich an, alle Anoden miteinander zu verbinden und gemeinsam nach außen zu führen, während jede Kathode mittels eines separaten Anschlusses 320 nach außen geführt wird.

Figur 4 zeigt eine schematische Darstellung einer Schnittansicht des Leuchtelements aus Figur 3. Die Schnittrichtung ist in Fig. 3 als A-A eingezeichnet. Die Lichtquelle 130 ist innerhalb der Vertiefung 340 des Gehäuses 310 angeordnet. Die Abdeckung 330 erlaubt das ungehinderte Austreten der Emissionen der Lichtquelle 130. Der die Lichtquelle 130 umgebende Hohlraum wird nach unten von der Bodenplatte 410 begrenzt. Die der Lichtquelle 130 zugewandten Wände des Gehäuses 310 können so geformt und beschaffen sein, dass sich eine Reflektorwirkung ergibt. Auf diese Weise kann die Ausbeute der durch die Abdeckung 330 fallenden Emissionen der Lichtquelle 130 maximiert werden.

Die Elektroden der Lichtquelle 130 und ihre Verbindungen zu den Anschlüssen 320 sind in dieser Darstellung nicht gezeigt.

Mit Hilfe der gezeigten Anordnung wird es möglich, Lichtquellen, die Emissionen unterschiedlicher Spektren aussenden, so anzuordnen und anzusteuern, dass die vom Reflektor zum Leuchtfeld gelenkten überlagerten Emissionen ein Spektrum aufweisen, welches in guter Näherung einer voreingestellten Farbtemperatur entspricht. Da die Überlagerung bzw. Mischung der Emissionen der Lichtquellen bereits stattfindet, bevor die Emissionen auf den Reflektor treffen, wird eine besonders gleichmäßige Überlagerung bzw. Vermischung erzielt, so dass der Schatten eines in den Bereich zwischen dem Reflektor 150 und dem Leuchtfeld 160 eingebrachten Objektes keinen nennenswerten Farbsaum aufweist. Mittels eines Kalibrierverfahrens ist es möglich, die Steuerung der Farbtemperatur im Leuchtfeld mit einem besonders hohen Farbwiedergabeindex über mehrere Farbtemperaturen hinweg zu steuern.

## Patentansprüche

1. Operationsleuchte (100) mit wenigstens einem Leuchtelement (110) und wenigstens einem optischen Abbildungssystem (150), wobei jedes Leuchtelement (110) wenigstens zwei Lichtquellen (120, 130, 140) hat und jede Lichtquelle (120, 130, 140) Emissionen eines Spektrums aussendet, wenigstens zwei Lichtquellen (120, 130, 140) des Leuchtelements (110) Emissionen mit verschiedenen Spektren aussenden, wobei die Lichtquellen (120, 130, 140) des Leuchtelements (110) in einem so geringen Abstand von einer optischen Achse des Leuchtelements (110) angeordnet sind, dass die Emissionen der Lichtquellen (120, 130, 140) überlagert werden, bevor sie auf das optische Abbildungssystem (150) treffen, **dadurch gekennzeichnet, dass** der Abstand des Zentrums jeder Lichtquelle (120, 130, 140) eines Leuchtelements (110) zur optischen Achse des Leuchtelements (110) weniger als 5 mm beträgt und wobei die Emissionen jeder Lichtquelle (120, 130, 140) eine einstellbare Intensität haben und dass die Intensität der Emissionen jeder Lichtquelle (120, 130, 140) mittels einer Stellgröße variabel ist.

2. Operationsleuchte (100) nach Anspruch 1, **dadurch gekennzeichnet, dass** der Abstand des Zentrums jeder Lichtquelle (120, 130, 140) eines Leuchtelements (110) zur optischen Achse des Leuchtelements (110) weniger als ca. 3 mm beträgt.

3. Operationsleuchte (100) nach einem der vorangehenden Ansprüche, **dadurch gekennzeichnet, dass** das optische Abbildungssystem (150) wenigstens einen Reflektor aufweist.

4. Operationsleuchte (100) nach dem vorangehenden Anspruch, **dadurch gekennzeichnet, dass** das Spektrum der Emissionen jeder Lichtquelle (120, 130, 140) einer der Farben weiß, warmweiß, rot, grün oder amber entspricht.

5. Operationsleuchte (100) nach einem der vorangehenden Ansprüche, **dadurch gekennzeichnet, dass** die Lichtquellen (120, 130, 140) Halbleiterkristalle sind.

6. Operationsleuchte (100) nach einem der vorangehenden Ansprüche, **dadurch gekennzeichnet, dass** die Lichtquellen (120, 130, 140) Leuchtdioden sind.

7. Operationsleuchte (100) nach einem der vorangehenden Ansprüche, **dadurch gekennzeichnet, dass** die Lichtquellen (120, 130, 140) eines Leuchtelements (110) in einem gemeinsamen Gehäuse untergebracht sind.

8. Operationsleuchte (100) nach einem der vorhergehenden Ansprüche, **dadurch gekennzeichnet, dass** die der Intensität der Emissionen der Lichtquelle (120, 130, 140) zugeordnete Stellgröße ein elektrischer Strom ist.

9. Operationsteuchte (100) nach einem der vorangehenden Ansprüche, **dadurch gekennzeichnet, dass** die Intensität der Emissionen jeder Lichtquelle (120, 130, 140) eines Leuchtelements (110) derart veränderbar ist, dass die auf das optische Abbildungssystem treffenden überlagerten Emissionen der Lichtquellen (120, 130, 140) eines Leuchtelements (110) ein vorgegebenes Spektrum aufweisen.

10. Operationsleuchte (100) nach einem der vorangehenden Ansprüche, **dadurch gekennzeichnet, dass** das Spektrum der auf das optische Abbildungssystem (150) treffenden Emissionen der Lichtquellen (120, 130, 140) eines Leuchtelements (110) mit einem Farbwiedergabeindex von wenigstens 90 einer vorgegebenen Farbtemperatur entspricht.

11. Operationsleuchte (100) nach Anspruch 10, **dadurch gekennzeichnet, dass** die vorgegebene Farbtemperatur im Bereich zwischen 3300 und 5500 Kelvin liegt.

12. Operationsleuchte (100) nach einem der vorangehenden Ansprüche, **dadurch gekennzeichnet, dass** sie eine Steuerung aufweist, welches ausgebildet ist, den Zusammenhang zwischen den Intensitäten der Emissionen von jeder Lichtquelle (120, 130, 140) zugeordneten Stellgrößen und erzielten Intensitäten der Emissionen der Lichtquellen (120, 130, 140) berücksichtigt und entsprechend die Intensitäten der Emissionen der Lichtquellen (120, 130, 140) derart einstellt, dass das Spektrum der überlagerten Emissionen der Lichtquellen (120, 130, 140) einer vorgegebenen Farbtemperatur entspricht.

13. Verfahren zum Steuern einer Farbtemperatur einer Operationsleuchte (100) mit wenigstens einem Leuchtelement (110), wobei das Leuchtelement (110) wenigstens zwei Lichtquellen (120, 130, 140) aufweist, welche Spektren aufweisende Emissionen aussenden und wenigstens zwei Lichtquellen (120, 130, 140) des Leuchtelements (110) Emissionen mit verschiedenen Spektren aussenden, folgende Schritte umfassend:
- Bestimmen des Zusammenhangs zwischen der der Intensität der Emissionen der Lichtquelle (120, 130, 140) zugeordneten Stellgröße und der erzielten Intensität der Emissionen jeder Lichtquelle (120, 130, 140) und
- Steuern der Intensitäten der Emissionen der Lichtquellen (120, 130, 140) derart, dass das Spektrum der überlagerten Emissionen der Lichtquellen (120, 130, 140) einer vorgegebenen Farbtemperatur mit einem Farbwiedergabeindex entspricht, der grösser oder gleich einem vorgegebenen Farbwiedergabeindex ist.

## Claims

1. Operating light (100) comprising at least one lighting element (110) and at least one optical imaging system (150), wherein each lighting element (110) has at least two light sources (120, 130, 140) and each light source (120, 130, 140) emits emissions of a spectrum, at least two light sources (120, 130, 140) of the lighting element (110) emitting emissions with different spectra, wherein the light sources (120, 130, 140) of the lighting element (110) are arranged at such a small distance from an optical axis of the lighting element (110) that the emissions of the light sources (120, 130, 140) are overlaid before they are incident on the optical imaging system (150), **characterized in that** the distance of the centre of each light source (120, 130, 140) of a lighting element (110) from the optical axis of the lighting element (110) is less than 5 mm and wherein the emissions of each Light source (120, 130, 140) have an adjustable intensity and **in that** the intensity of the emissions of each light source (120, 130, 140) is variable by means of a manipulated variable.

2. Operating Light (100) according to Claim 1, **characterized in that** the distance of the centre of each light source (120, 130, 140) of a lighting element (110) from the optical axis of the lighting element (110) is less than approximately 3 mm.

3. Operating Light (100) according to any one of the preceding claims, **characterized in that** the optical imaging system (150) comprises at least one reflector.

4. Operating light (100) according to the preceding claim, **characterized in that** the spectrum of the emissions of each light source (120, 130, 140) corresponds to one of the following colours: white, warm white, red, green or amber.

5. Operating light (100) according to any one of the preceding claims, **characterized in that** the light sources (120, 130, 140) are semiconductor crystals.

6. Operating light (100) according to any one of the preceding claims, **characterized in that** the light sources (120, 130, 140) are light-emitting diodes.

7. Operating light (100) according to any one of the preceding claims, **characterized in that** the light sources (120, 130, 140) of a lighting element (110) are accommodated in a common housing.

8. Operating light (100) according to any one of the preceding claims, **characterized in that** the manipulated variable assigned to the intensity of the emissions of the light source (120, 130, 140) is an electric current.

9. Operating light (100) according to any one of the preceding claims, **characterized in that** the intensity of the emissions of each light source (120, 130, 140) of a lighting element (110) is modifiable in such a way that the overlaid emissions of the light sources (120, 130, 140) of a lighting element (110) incident on the optical imaging system have a predetermined spectrum.

10. Operating light (100) according to any one of the preceding claims, **characterized in that** the spectrum of the emissions of the Light sources (120, 130, 140) of a lighting element (110) incident on the optical imaging system (150) corresponds to a predetermined colour temperature with a colour rendering index of at least 90.

11. Operating light (100) according to Claim 10, **characterized in that** the predetermined colour temperature lies in the region between 3300 and 5500 kelvin.

12. Operating light (100) according to any one of the preceding claims, **characterized in that** it comprises a controller embodied to take into account the relationship between manipulated variables assigned to the intensities of the emissions of each light source (120, 130, 140) and obtained intensities of the emissions of the light sources (120, 130, 140) and accordingly set the intensities of the emissions of the light sources (120, 130, 140) in such a way that the spectrum of the overlaid emissions of the light sources (120, 130, 140) corresponds to a predetermined colour temperature.

13. Method for controlling a colour temperature of an operating light (100) comprising at least one lighting element (110), wherein the lighting element (110) has at least two light sources (120, 130, 140) which emit emissions having spectra and at least two light sources (120, 130, 140) of the lighting element (110) emit emissions with different spectra, comprising the following steps:
- determining the relationship between the manipulated variable assigned to the intensity of the emissions of the light source (120, 130, 140) and the obtained intensity of the emissions of each light source (120, 130, 140), and
- controlling the intensities of the emissions of the light sources (120, 130, 140) in such a way that the spectrum of the overlaid emissions of the light sources (120, 130, 140) corresponds to a predetermined colour temperature with a colour rendering index which is greater than or equal to a predetermined colour rendering index.

## Revendications

1. Scialytique (100), avec au moins un élément lumineux (110) et au moins un système de reproduction (150) optique, chaque élément lumineux (110) ayant au moins deux sources lumineuses (120, 130, 140) et chaque source lumineuse (120, 130, 140) émettant des émissions dans un spectre, au moins deux sources lumineuses (120, 130, 140) de l'élément lumineux (110) émettant des émissions dans différents spectres,
les sources lumineuses (120, 130, 140) de l'élément lumineux (110) étant placées avec un si faible écart par rapport à un axe optique de l'élément lumineux (110) que les émissions des sources lumineuses (120, 130, 140) se superposent avant d'être incidentes sur le système de reproduction (150) optique,
**caractérisé en ce que** l'écart entre le centre de chaque source lumineuse (120, 130, 140) d'un élément lumineux (110) et l'axe optique de l'élément lumineux (110) est de moins de 5 mm et les émissions de chaque source lumineuse (120, 130, 140) ayant une intensité réglable et **en ce que** l'intensité des émissions de chaque source lumineuse (120, 130, 140) est variable au moyen d'une grandeur de commande.

2. Scialytique (100) selon la revendication 1, **caractérisé en ce que** l'écart entre le centre de chaque source lumineuse (120, 130, 140) d'un élément lumineux (110) et l'axe optique de l'élément lumineux (110) est inférieur à environ 3 mm.

3. Scialytique (100) selon l'une quelconque des revendications précédentes, **caractérisé en ce que** le système de reproduction (150) optique comporte au moins un réflecteur.

4. Scialytique (100) selon la revendication précédente, **caractérisé en ce que** le spectre des émissions de chaque source lumineuse (120, 130, 140) correspond à l'une des couleurs blanc, blanc chaud, rouge, vert ou ambre.

5. Scialytique (100) selon l'une quelconque des revendications précédentes, **caractérisé en ce que** les sources lumineuses (120, 130, 140) sont des cristaux semi-conducteurs.

6. Scialytique (100) selon l'une quelconque des revendications précédentes, **caractérisé en ce que** les sources lumineuses (120, 130, 140) sont des diodes électroluminescentes.

7. Scialytique (100) selon l'une quelconque des revendications précédentes, **caractérisé en ce que** les sources lumineuses (120, 130, 140) d'un élément lumineux (110) sont logées dans un boîtier commun.

8. Scialytique (100) selon l'une quelconque des revendications précédentes, **caractérisé en ce que** la grandeur de commande associée à l'intensité des émissions de la source lumineuse (120, 130, 140) est un courant électrique.

9. Scialytique (100) selon l'une quelconque des revendications précédentes, **caractérisé en ce que** l'intensité des émissions de chaque source lumineuse (120, 130, 140) d'un élément lumineux (110) est variable de telle sorte que les émissions superposées des sources Lumineuses (120, 130, 140) d'un élément lumineux (110) qui sont incidentes sur le système de reproduction optique présentent un spectre prédéfini.

10. Scialytique (100) selon l'une quelconque des revendications précédentes, **caractérisé en ce qu'**avec un indice de rendu des couleurs d'au moins 90, le spectre des émissions des sources lumineuses (120, 130, 140) d'un élément lumineux (110) qui sont incidentes sur le système de reproduction optique (150) correspond à une température de couleur prédéfinie.

11. Scialytique (100) selon la revendication 10, **caractérisé en ce que** la température de couleur prédéfinie se situe dans un ordre compris entre 3300 et 5500 Kelvin.

12. Scialytique (100) selon l'une quelconque des revendications précédentes, **caractérisé en ce qu'**il comporte un système de commande, lequel est conçu pour tenir compte de la relation entre les grandeurs de commande associées à des intensités des émissions de chaque source lumineuse (120, 130, 140) et des intensités obtenues pour les émissions des sources lumineuses (120, 130, 140) et pour régler les intensités des émissions des sources lumineuses (120, 130, 140) de telle sorte que le spectre des émissions superposées des sources lumineuses (120, 130, 140) corresponde à une température de couleur prédéfinie.

13. Procédé destiné à commander une température de couleur d'un scialytique (100) avec au moins un élément lumineux (110), l'élément lumineux (110) comportant au moins deux sources lumineuses (120, 130, 140) lesquelles émettent des émissions présentant des spectres et au moins deux sources lumineuses (120, 130, 140) de l'élément lumineux (110) émettant des émissions dans différents spectres, comprenant les étapes de:
la détermination de la relation entre la grandeur de commande associée à l'intensité des émissions de la source lumineuse (120, 130, 140) et l'intensité obtenue des émissions de chaque source lumineuse (120, 130, 140) et
la commande des intensités des émissions des sources lumineuses (120, 130, 140) de telle sorte que le spectre des émissions superposées des sources Lumineuses (120, 130, 140) corresponde à une température de couleur prédéfinie avec un indice de rendu des couleurs qui est supérieur ou égal à un indice de rendu des couleurs prédéfini.
